# EUROPEAN PATENT SPECIFICATION

(11) **EP 1 637 624 B1**
(45) Date of publication and mention of the grant of the patent: **30.05.2012**
(21) Application number: 03733231.9
(22) Date of filing: 02.06.2003
(51) Int. Cl.: C23C 14/34, C23C 16/50, C23F 4/00, H01L 21/31

(54) **THIN FILM FORMING APPARATUS**
VORRICHTUNG ZUR AUSBILDUNG VON DÜNNEM FILM
DISPOSITIF DE FORMATION DE COUCHES MINCES

(43) Date of publication of application: 22.03.2006
(73) Proprietor: Shincron Co., Ltd., Kanagawa 220-8680 (JP)
(72) Inventor: SONG, Yizhou, Saitama 332-0011 (JP); SAKURAI, Takeshi, Yokohama-shi, Kanagawa 223-0052 (JP); MURATA, Takanori, Yokohama-shi, Kanagawa, 230-0011 (JP)
(74) Representative: Grünecker, Kinkeldey, Stockmair & Schwanhäusser
(86) International application number: PCT/JP2003/006951
(87) International publication number: WO 2004/108979

(56) References cited:
- EP-A- 1 079 671
- EP-A- 1 640 474
- WO-A-00/00993
- JP-A- 5 185 247
- JP-A- 8 031 358
- JP-A- 9 245 997
- JP-A- 11 209 875
- JP-A- 2000 208 298
- JP-A- 2001 234 338
- JP-A- 2002 316 293
- US-B1- 6 254 738

## Description

### TECHNICAL FIELD

The present invention relates to a thin film deposition apparatus for forming thin films for use as optical thin films and for use in optical devices, optoelectronic devices, semiconductor devices, and the like. More particularly, the invention relates to a thin film deposition apparatus in which the density of active species, which undergo a chemical reaction with a thin film, is increased through improvement of plasma generation means and a vacuum container, as well as to a thin film deposition method using the thin film deposition apparatus.

### BACKGROUND ART

Conventionally, plasma processing, such as deposition of a thin film on a substrate, modification of the surface of a deposited thin film, or etching, has been performed by use of a reactive gas in plasma state in a vacuum container. For example, in a known technique for forming a thin film of a metal compound (disclosed in, for example, Japanese Patent Application Laid-Open (kokai) No. 2001-234338), a thin film of an incomplete reaction product of metal is deposited on a substrate by use of a sputtering technique, and the thin film of the incomplete reaction product is brought into contact with a reactive gas in plasma state, thereby forming a thin film of a metal compound.

The known technique uses plasma generating means in order to excite a reactive gas into plasma state in a vacuum container of a thin film deposition apparatus. The gas that is excited into plasma state by the plasma generating means contains ions, electrons, atoms, molecules, and active species (radicals, excited radicals, and the like). Electrons and ions contained in the plasma gas may damage a thin film, but in many cases radicals of a reactive gas, which are electrically neutral, contribute to deposition of a thin film. Thus, the conventional technique uses a grid in order to prevent electrons and ions from heading toward a thin film on a substrate so as to selectively bring radicals into contact with the thin film. Use of a grid increases the relative density of radicals-which contribute to deposition of a thin film-in a plasma gas, thereby enhancing the efficiency of plasma processing.

However, use of a grid in order to increase the relative density of radicals involves the following problems: the structure of a thin film deposition apparatus becomes complex; and the dimensions, shape, and arrangement of a grid impose limitation on the range of distribution of radicals within the vacuum container. Involvement of the problems hinders performance of plasma processing over a wide range and thus impairs the efficiency of plasma processing, thus hindering enhancement of thin-film production efficiency. When the size of a grid is increased in order to increase the range of distribution of radicals, costs increase.

Conventionally, a parallel-plate-type apparatus, an ECR-type apparatus, an inductively-coupled-type apparatus, and the like are known as plasma generating means for generating a plasma. Inductively-coupled-type apparatus are known to be classified into a cylindrical type and a plate type.

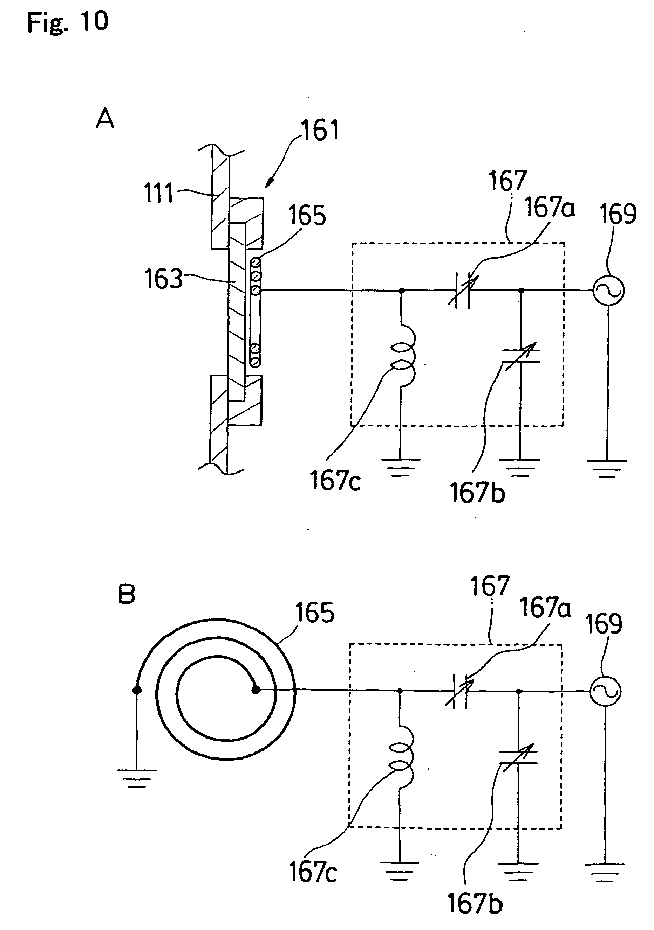

FIG. 10 is a view for explaining a conventional plate-type plasma generator 161. FIG. 10A is a sectional view showing a portion of a thin film deposition apparatus. As shown in FIG. 10A, in conventional plate-type plasma generating means, a dielectric plate 163-which is formed of a dielectric such as quartz-partially constitutes a vacuum container 111; and an antenna 165 is disposed along the outer wall of the dielectric plate 163-the outer wall faces the atmosphere.

The shape of the antenna 165 is shown in FIG. 10B. The antenna 165 spirals in a plane. In the conventional plate-type plasma generator 161, an RF power supply 169 applies power having a frequency of 100 kHz to 50 MHz to the antenna 165 via a matching box 167 having a matching circuit, thereby generating a plasma within the vacuum container 111.

RF power is applied to the antenna 165 via a matching circuit adapted to perform impedance matching-the matching circuit is represented by the matching box 167 shown in FIG. 10. As shown in FIG. 10, the matching circuit is connected to the antenna 165 and to the RF power supply 169 while intervening therebetween, and includes variable capacitors 167a and 167b and a matching coil 167c.

In the conventional plasma generating means, when plasma processing is to be performed over a wide range within the vacuum container, the size of the antenna 165 is increased. However, this involves an increase in power loss in the antenna 165 and in the matching coil 167c and causes difficulty in establishing impedance match. Also, when plasma processing is performed over a wide range, the density of a plasma fails to become uniform over the range.

Another known thin film deposition apparatus is disclosed in document WO-A-0 000 993.

In view of the above problems, an object of the present invention is to provide a thin film deposition apparatus in which plasma processing can be performed efficiently over a wide range.

### DISCLOSURE OF THE INVENTION

A thin film deposition apparatus according to the present invention comprises the features of claim 1.

Since the thin film deposition apparatus of the present invention includes the first antenna and the second antenna, the distribution of a plasma can be readily adjusted by independently adjusting parameters, such as thickness, shape, size, and diameter, of the first and second antennas. In the thin film deposition apparatus of the present invention, the position adjusting means for adjusting the distance between the first antenna and the second antenna is provided in the conductor wire extending from the RF power supply to the first and second antennas at a portion that connects the first antenna and the second antenna. Thus, the distribution of a plasma can be readily adjusted by adjusting the distance between the first antenna and the second antenna. Even when a matching circuit is connected to the first and second antennas, parallel connection of the first and second antennas facilitates impedance matching in the matching circuit and reduces power loss in the matching circuit to thereby allow effective use of power for generation of a plasma.

The matching box for impedance matching is provided. The matching box mounts between the plasma generating means and the RF power supply. And the matching box does not have the matching coil for impedance matching.

Since the matching box does not have the matching coil for impedance matching, the antenna bears the function of impedance matching. Accordingly, it is possible to reduce power loss in the matching box and facilitate impedance matching, as compared with the conventional constitution that the matching coil for impedance matching is provided in the matching box. Then, plasma processing can be performed efficiently.

Preferably, substrate transport means for transporting substrates is provided in the vacuum container; the transport means transports substrates such that the substrates face a plane in which the first antenna and the second antenna form respective spirals; and the first antenna and the second antenna are fixed while being arranged adjacent to each other in a direction intersecting a direction in which the substrates are transported by the substrate transport means.

Since the first antenna and the second antenna are fixed while being arranged adjacent to each other in a direction intersecting the direction in which substrates are transported, the density distribution of a plasma can be readily adjusted in a direction perpendicular to the direction in which substrates are transported. Therefore, plasma processing can be performed over a wide range in a direction perpendicular to the direction in which substrates are transported, so that a large quantity of thin film can undergo plasma processing in a single operation.

Preferably, each of the first antenna and the second antenna comprises a body member assuming the form of a round tube and formed of a first material, and a coating layer covering a surface of the body member and formed of a second material having electric resistance lower than that of the first material.

Through employment of the above antenna structure, a material that is inexpensive and easily worked can be used as the first material in order to form the body members of the first and second antennas; and a material having low electric resistance can be used as the second material in order to form the coating layer, in which current concentrates. Thus, the high-frequency impedance of the antennas can be lowered, so that a thin film can be efficiently formed.

Other advantages of the present invention will become apparent from the below description.

### BRIEF DESCRIPTION OF DRAWINGS

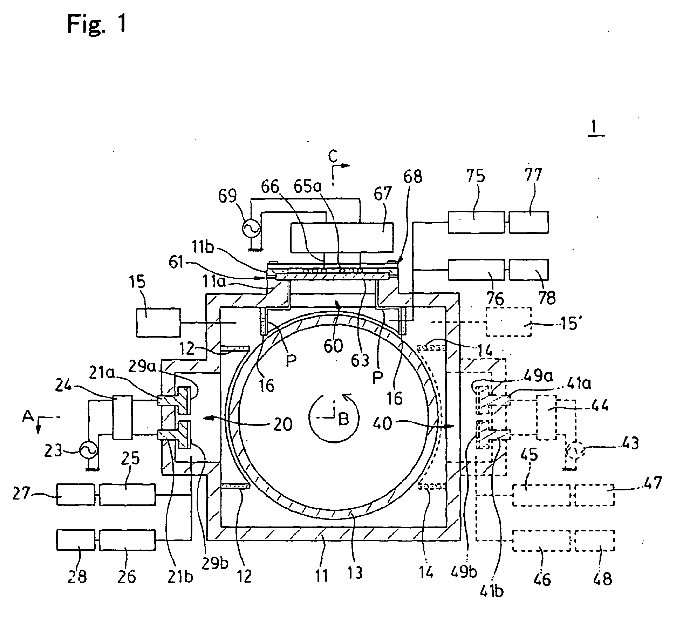

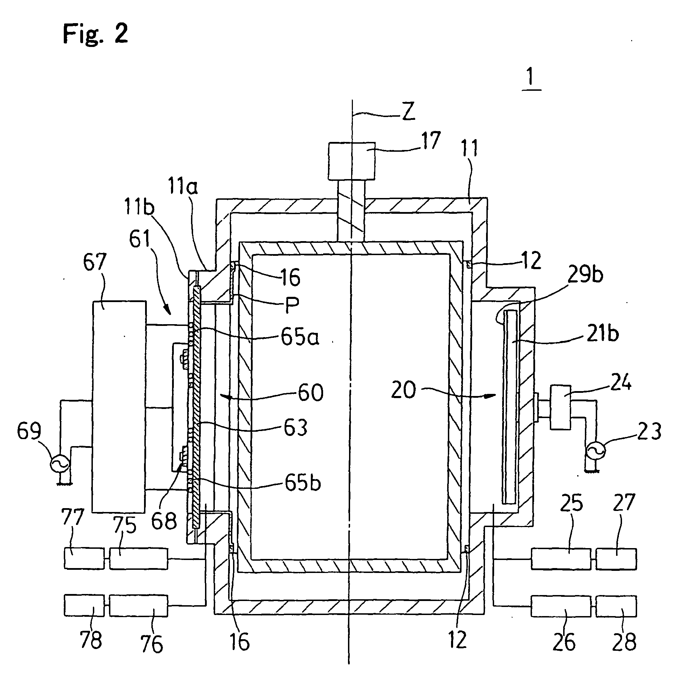

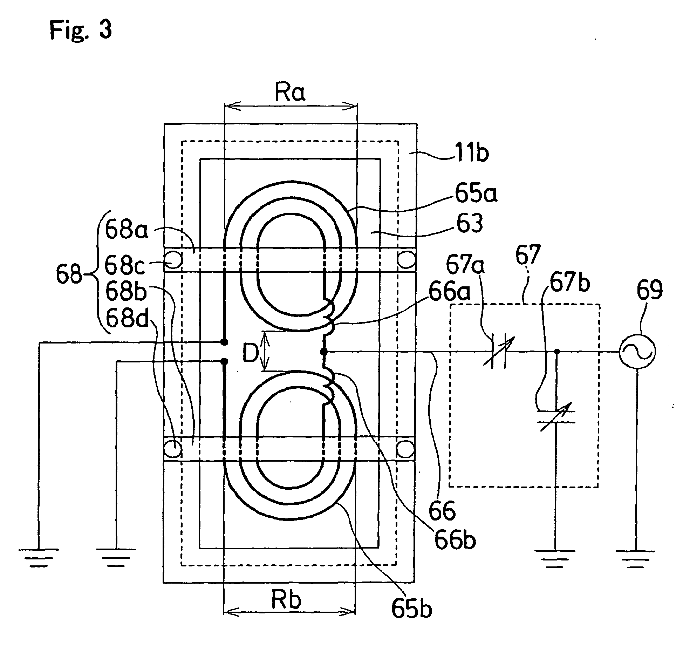

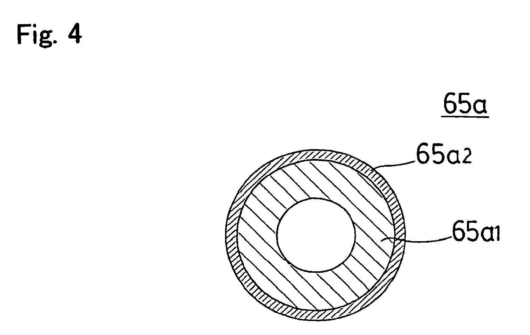

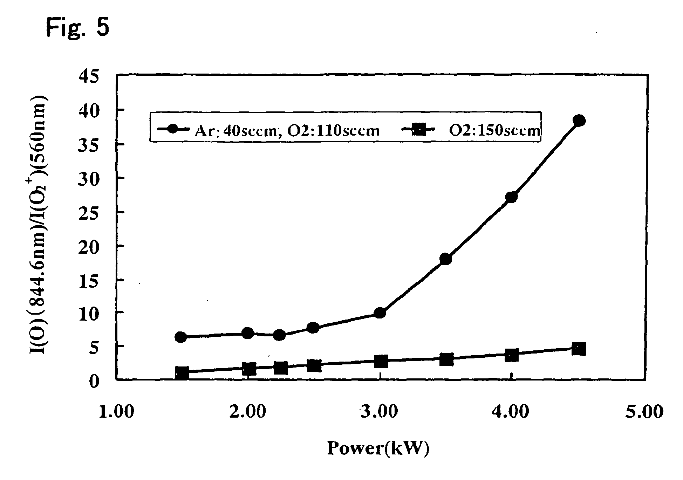

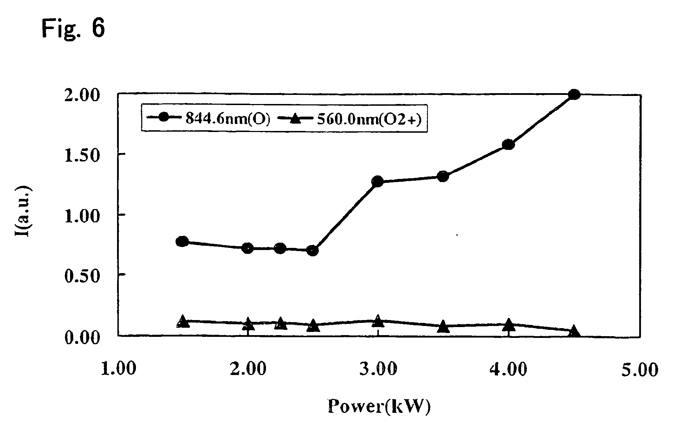

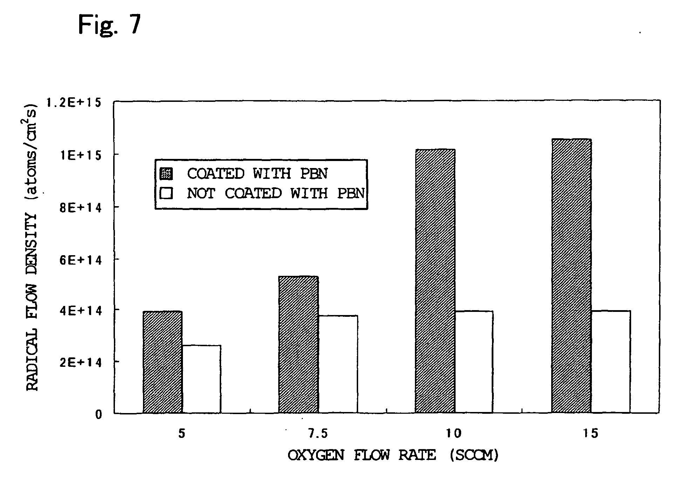

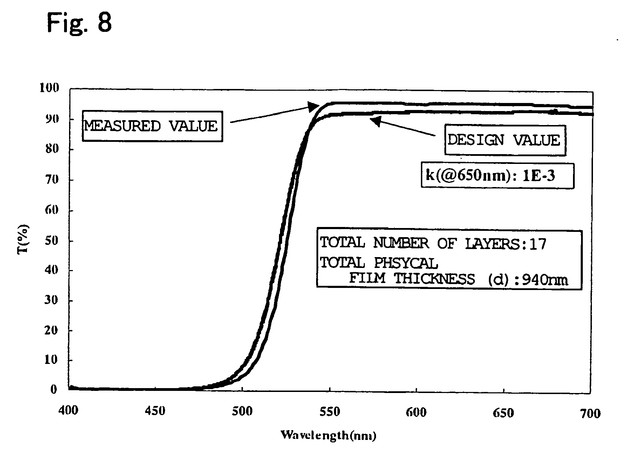

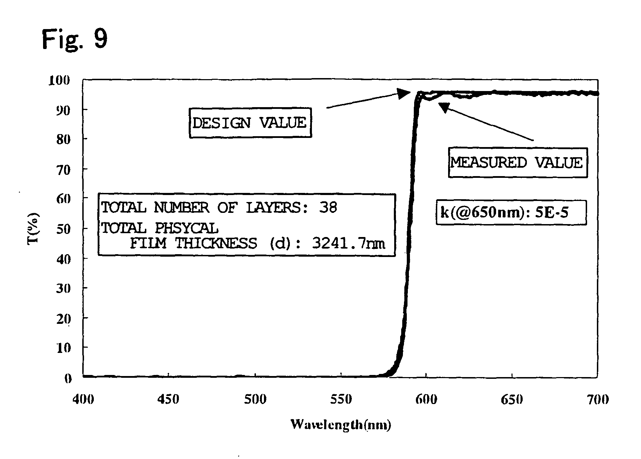

FIG. 1 is a partially sectional, explanatory top view for explaining a thin film deposition apparatus of the present invention; FIG. 2 is a partially sectional, explanatory side view for explaining the thin film deposition apparatus of the present invention; FIG. 3 is an explanatory view for explaining plasma generating means; FIG. 4 is a sectional view of an antenna; FIG. 5 is a graph of example test results, showing the results of measurement of proportion of oxygen atoms and oxygen ions contained in a plasma; FIG. 6 is a graph of example test results, showing the results of measurement of emission intensity of excited oxygen radicals and oxygen ions contained in a plasma; FIG. 7 is a graph of example test results, showing the results of measurement of flow density of oxygen radicals contained in a plasma; FIG. 8 is a graph of example test results, showing the results of measurement of transmittance of a multilayered thin film that is formed of silicon oxide and niobium oxide by use of conventional plasma generating means; FIG. 9 is a graph of example test results, showing the results of measurement of transmittance of a multilayered thin film that is formed of niobium oxide and silicon oxide by use of plasma generating means of the present invention; and FIG. 10 is an explanatory view for explaining conventional plate-type plasma generating means.

### BEST MODE FOR CARRYING OUT THE INVENTION

An embodiment of the present invention will next be described in detail with reference to the drawings. Members, arrangement, and the like to be described below should not be construed as limiting the invention, but may be modified in various forms without departing from the scope of the invention.

FIGS. 1 and 2 are explanatory views for explaining a sputtering apparatus 1. FIG. 1 is an explanatory top view with a partial section provided for easy understanding. FIG. 2 is a partially sectional, explanatory side view taken along line A-B-C of FIG. 1. The sputtering apparatus 1 is an example of a thin film deposition apparatus of the present invention.

The sputtering apparatus 1 of the present embodiment performs magnetron sputtering, which is a type of sputtering. However, the type of sputtering is not limited thereto. The sputtering apparatus 1 may perform another known type of sputtering, such as diode sputtering without use of magnetron discharge.

The sputtering apparatus 1 of the present embodiment repeats a cycle of depositing a thin film considerably thinner than a target thickness on a substrate by sputtering, and performing plasma processing on the thin film, thereby forming on the substrate a thin film having the target thickness. The present embodiment repeats the step of forming a thin film having an average thickness of 0.01 nm to 1.5 nm by means of sputtering and plasma processing, thereby forming a thin film having a target thickness of several nanometers to several hundreds of nanometers.

Major components of the sputtering apparatus 1 of the present embodiment include a vacuum container 11; a substrate holder 13 for holding substrates, on which a thin film is to be formed, within the vacuum container 11; a motor 17 for driving the substrate holder 13; partitions 12 and 16; magnetron sputter electrodes 21a and 21b; an intermediate frequency AC power supply 23; and a plasma generator 61 for generating a plasma. The partition 16 corresponds to a plasma converging wall of the present invention; the plasma generator 61 corresponds to plasma generating means of the present invention; and the substrate holder 13 and the motor 17 correspond to substrate transport means of the present invention.

As in the case of a known sputtering apparatus, the vacuum container 11 is a hollow stainless steel body generally assuming the shape of a rectangular parallelepiped. The vacuum container 11 may assume a hollow, cylindrical shape.

The substrate holder 13 is disposed within the vacuum container 11 substantially at the center. The substrate holder 13 assumes a cylindrical shape and holds a plurality of substrates (not shown) on its outer circumferential surface. The shape of the substrate holder 13 is not limited to a cylindrical shape, but may be a hollow prismatic shape or a hollow conical shape. The substrate holder 13 is electrically insulated from the vacuum container 11, thereby preventing anomalous discharge in substrates. The substrate holder 13 is disposed within the vacuum container 11 such that a Z axis (see FIG. 2) of its cylindrical shape coincides with the vertical direction of the vacuum container 11. The substrate holder 13 is rotated about the Z axis by means of the motor 17 provided above the vacuum container 11 while a vacuum is maintained within the vacuum container 11.

A number of substrates (not shown) are held on the outer circumferential surface of the substrate holder 13 while being arrayed at predetermined intervals along the direction of the Z axis (along the vertical direction). In the present embodiment, a substrate is held on the substrate holder 13 such that its surface (hereinafter referred to as a "film deposition surface") on which a thin film is to be formed faces a direction perpendicular to the Z axis of the substrate holder 13.

The partitions 12 and 16 are provided on the inner wall surface of the vacuum container 11 and extend toward the substrate holder 13. In the present embodiment, the partition 12 (16) is a stainless steel member that assumes the shape of an open-ended tubular, rectangular parallelepiped. The partition 12 (16) is fixed on an inner side wall of the vacuum container 11 and extends toward the substrate holder 13. The partition 12 (16) is fixed such that one opening is located on the side toward the inner side wall of the vacuum container 11, whereas the other opening faces the substrate holder 13. An end portion of the partition 12 (16) that faces the substrate holder 13 assumes a shape corresponding to the circumferential outline of the substrate holder 13.

A film deposition process zone 20 for performing sputtering is formed in such a manner as to be surrounded by the inner wall surface of the vacuum container 11, the partition 12, and the outer circumferential surface of the substrate holder 13. A reaction process zone 60 for generating a plasma in order to perform plasma processing on thin films formed on corresponding substrates is formed in such a manner as to be surrounded by the inner wall surface of the vacuum container 11, the plasma generator 61 to be described later, the partition 16, and the outer circumferential surface of the substrate holder 13. In the present embodiment, the partitions 12 and 16 of the vacuum container 11 are shifted in position from each other by about 90 degrees about the Z axis of the substrate holder 13. Thus, the film deposition process zone 20 and the reaction process zone 60 are shifted in position from each other by about 90 degrees about the Z axis of the substrate holder 13. When the substrate holder 13 is rotated by means of the motor 17, substrates held on the outer circumferential surface of the substrate holder 13 are transported between a position where the substrates face the film deposition process zone 20, and a position where the substrates face the reaction process zone 60.

Exhaust piping is connected to a zone of the vacuum container 11 located between the film deposition process zone 20 and the reaction process zone 60. A vacuum pump 15 is connected to the exhaust piping in order to evacuate the vacuum container 11. The vacuum pump 15 and an unillustrated controller are adapted to adjust the degree of vacuum within the vacuum container 11.

The wall surface of the partition 16 that faces the reaction process zone 60 is coated with a protection layer P formed of pyrolytic boron nitride. A portion of the inner wall surface of the vacuum container 11 that faces the reaction process zone 60 is also coated with the protection layer P formed of pyrolytic boron nitride. Pyrolytic boron nitride is deposited on the wall surface of the partition 16 and on the inner wall surface of the vacuum container 11 by a pyrolysis process that utilizes chemical vapor deposition.

Mass flow controllers 25 and 26 are connected to the film deposition process zone 20 via piping. The mass flow controller 25 is connected to a sputter gas container 27 that stores an inert gas. The mass flow controller 26 is connected to a reactive gas container 28 that stores a reactive gas. An inert gas and a reactive gas are introduced into the film deposition process zone 20 under control of the mass flow controllers 25 and 26, respectively. Examples of an applicable inert gas include argon gas. Examples of an applicable reactive gas include oxygen gas, nitrogen gas, fluorine gas, and ozone gas.

In the film deposition process zone 20, the magnetron sputter electrodes 21a and 21b are arranged on the wall surface of the vacuum container 11 in such a manner that they face the outer circumferential surface of the substrate holder 13. The magnetron sputter electrodes 21a and 21b are fixed to the vacuum container 11, which has the ground potential, via an unillustrated insulating member. The magnetron sputter electrodes 21a and 21b are connected to the intermediate frequency AC power supply 23 via a transformer 24, so that an alternating electric field can be applied thereto. In the present embodiment, the intermediate frequency AC power supply 23 applies an alternating electric field of 1 kHz to 100 kHz. Targets 29a and 29b are held on the magnetron sputter electrodes 21a and 21b, respectively. The targets 29a and 29b assume the shape of a flat plate. The targets 29a and 29b are held in such a manner as to face a direction perpendicular to the Z axis of the substrate holder 13; i.e., to face the outer circumferential surface of the substrate holder 13.

Notably, instead of a single film deposition process zone, where sputtering is performed, a plurality of film deposition process zones may be provided. Specifically, as represented by the dashed line in FIG. 1, a film deposition process zone 40 similar to the film deposition process zone 20 can additionally be provided in the vacuum container 11. For example, the film deposition process zone 40 can be formed through provision of a partition 14 in the vacuum container 11 such that the film deposition process zone 40 and the film deposition process zone 20 are located symmetrically in relation to the substrate holder 13. As in the case of the film deposition process zone 20, magnetron sputter electrodes 41a and 41b are arranged in the film deposition process zone 40. The magnetron sputter electrodes 41a and 41b are connected to an intermediate frequency AC power supply 43 via a transformer 44, so that an alternating electric field can be applied thereto. Targets 49a and 49b are held on the magnetron sputter electrodes 41a and 41b, respectively. Mass flow controllers 45 and 46 are connected to the film deposition zone 40 via piping. The mass flow controller 45 is connected to a sputter gas container 47 that stores an inert gas. The mass flow controller 46 is connected to a reactive gas container 48 that stores a reactive gas. Exhaust piping is connected to a zone of the vacuum container 11 located between the film deposition process zone 40 and the reaction process zone 60. A vacuum pump 15' is connected to the exhaust piping in order to evacuate the vacuum container 11. The vacuum pump 15 may be used in common so as to serve as the vacuum pump 15'.

An opening is formed in a wall of the vacuum container 11 that corresponds to the reaction process zone 60. The plasma generator 61, which serves as plasma generating means, is connected to the opening. The following piping, which serves as gas introduction means of the present invention, is connected to the reaction process zone 60: piping for introducing an inert gas from an inert gas container 77 via a mass flow controller 75; and piping for introducing a reactive gas from a reactive gas container 78 via a mass flow controller 76.

FIG. 3 is an explanatory view for explaining the plasma generator 61, showing the front view of the plasma generator 61. FIG. 3 also shows a matching box 67 and an RF power supply 69.

The plasma generator 61 includes a dielectric wall 63, which is formed into a plate-like shape from a dielectric; antennas 65a and 65b, which are spiraled on the same plane; a conductor wire 66 for connecting the antennas 65a and 65b to the RF power supply 69; and a fixture 68 for fixing the antennas 65a and 65b to the dielectric wall 63. The antenna 65a corresponds to a first antenna of the present invention; the antenna 65b corresponds to a second antenna of the present invention; and the fixture 68 corresponds to antenna fixing means of the present invention.

In the present embodiment, the dielectric wall 63 is formed of quartz. In place of quartz, another ceramic material, such as Al₂O₃, may be used to form the dielectric wall 63. While being held between a rectangular frame-like cover 11b and a flange 11a formed on the vacuum container 11, the dielectric wall 63 is positioned in such a manner as to cover the opening, which is formed in a wall of the vacuum container 11 to correspond to the reaction process zone 60. The antennas 65a and 65b are fixed to the dielectric wall 63 by means of the fixture 68 at the outside of the vacuum container 11 in such a manner as to be vertically adjacent to each other and such that the plane in which the antennas 65a and 65b are spiraled faces the interior of the vacuum container 11 (see FIGS. 2 and 3). Thus, when the motor 17 rotates the substrate holder 13 about the Z axis, substrates held on the outer circumferential surface of the substrate holder 13 are transported in such a manner as to face the plane in which the antennas 65a and 65b are spiraled. In other words, in the present embodiment, since the antennas 65a and 65b are fixed vertically adjacent to each other, the antennas 65a and 65b are fixed while being arranged adjacent to each other in a direction (in the vertical direction in the present embodiment) intersecting the direction in which the substrates are transported.

In the present embodiment, the fixture 68 includes fixing plates 68a and 68b and bolts 68c and 68d. The antenna 65a is held between the fixing plate 68a and the dielectric wall 63; the antenna 65b is held between the fixing plate 68b and the dielectric wall 63; and the fixing plates 68a and 68b are fixed to the cover 11b by fastening the bolts 68c and 68d, to thereby fix the antennas 65a and 65b.

The antennas 65a and 65b are connected, in parallel in relation to the RF power supply 69, to an end of the conductor wire 66, which extends between the RF power supply 69 and the antennas 65a and 65b. The antennas 65a and 65b are connected to the RF power supply 69 via the matching box 67, which accommodates a matching circuit. As shown in FIG. 3, variable capacitors 67a and 67b are provided within the matching box 67. In the present embodiment, since the antenna 65a and the antenna 65b are connected in parallel, the antenna 65b entirely or partially plays the role that the matching coil 167c plays in the conventional matching circuit (see FIG. 10). Thus, power loss in the matching box 67 is reduced, so that power supplied from the RF power supply 69 can be effectively used in the antennas 65a and 65b for generating a plasma. Also, impedance matching is facilitated.

In order to enable adjustment of a distance D between the antenna 65a and the antenna 65b, slack portions 66a and 66b are provided at a connection portion which connects the antenna 65a and the antenna 65b together and which is connected to an end of the conductor wire 66. The slack portions 66a and 66b correspond to position adjusting means of the present invention. In the sputtering apparatus 1 of the present embodiment, when the antennas 65a and 65b are to be fixed by means of the fixture 68, the vertical distance D between the antenna 65a and the antenna 65b can be adjusted by expanding or contracting the slack portions 66a and 66b. In other words, the distance D can be adjusted by changing the positions of the antennas 65a and 65b at which the antennas 65a and 65b are held between the dielectric wall 63 and the fixing plates 68a and 68b, respectively.

FIG. 4 is a sectional view of the antenna 65a. In the present embodiment, the antenna 65a includes a body member 65a₁ assuming the form of a round tube and formed of copper, and a coating layer 65a₂ covering the surface of the body member 65a₁ and formed of silver. Preferably, in order to lower the impedance of the antenna 65a, a material having low electric resistance is used to form the antenna 65a. Through utilization of a characteristic that RF current concentrates on the surface of an antenna, the body member 65a₁ is formed into a round tube from copper, which is inexpensive, easily worked, and low in electric resistance, whereas the outer surface of the body member 65a₁ is coated with silver, which is lower in electric resistance than copper, thereby forming the coating layer 65a₂. Employment of the above configuration lowers the RF-related impedance of the antennas 65a and 65b and allows efficient flow of current through the antenna 65a, thereby enhancing plasma generation efficiency. As in the case of the antenna 65a, the antenna 65b includes a body member 65b₁ formed of copper, and a coating layer 65b₂ formed of silver. Of course, the antennas 65a and 65b can be modified in terms of sectional size (thickness). In the present embodiment, a similar structure is imparted to the slack portions 66a and 66b; i.e., the slack portions 66a and 66b are formed into a round tube from copper, and their surfaces are coated with silver.

In the plasma generator 61 used in the present embodiment, after adjustment of the vertical distance D between the antenna 65a and the antenna 65b, the diameter Ra of the antenna 65a, the diameter Rb of the antenna 65b, and the like, the antennas 65a and 65b are fixed; and a reactive gas contained in the reactive gas container 78 is introduced via the mass flow controller 75 into the reaction process zone 60, which is maintained at a vacuum of about 0.1 Pa to 10 Pa. Then, voltage having a frequency of 13.56 MHz is applied to the antennas 65a and 65b from the RF power supply 69, whereby a plasma of the reactive gas can be generated with a desired distribution in the reaction process zone 60 in order to perform plasma processing on substrates arranged on the substrate holder 13.

In the present embodiment, as compared with the case of using a single large antenna, employment of two antennas 65a and 65b connected in parallel and the slack portions 66a and 66b lowers power loss in the matching circuit contained in the matching box 67 and facilitates impedance matching. Thus, plasma processing can be performed efficiently over a wide range.

Furthermore, the body members 65a₁ and 65b₁ of the antennas 65a and 65b, respectively, are formed into a round tube from copper, which is inexpensive, easily worked, and low in electric resistance, and the coating layers 65a₂ and 65b₂ are formed of silver, which is lower in electric resistance than copper. Thus, RF-related impedance of the antennas 65a and 65b can be lowered, so that plasma processing can be performed efficiently with low power loss.

In the present embodiment, through adjustment of the vertical distance D between the antenna 65a and the antenna 65b, the distribution of a plasma can be adjusted in relation to substrates arranged on the substrate holder 13. Since the diameters Ra and Rb of the antennas 65a and 65b, respectively, the thickness of the antennas 65a and 65b, and the like can be modified independently, the distribution of a plasma can also be adjusted through adjustment of, for example, the diameters Ra and Rb of the antennas 65a and 65b or the thickness of the antennas 65a and 65b. In the present embodiment, as shown in FIG. 3, the antennas 65a and 65b are each shaped like a group of semicircles of different sizes. However, the overall shape of each of the antennas 65a and 65b may be modified to a rectangular shape in order to adjust the distribution of a plasma.

Particularly, since the antenna 65a and the antenna 65b are arranged adjacent to each other in a direction intersecting the direction in which substrates are transported, and the distance between the antenna 65a and the antenna 65b can be adjusted, in the case where plasma processing must be performed over a wide range in a direction intersecting the direction in which substrates are transported, the density distribution of a plasma can be readily adjusted. For example, when plasma processing is performed by use of the carousel-type sputtering apparatus 1 as in the case of the present embodiment, substrates located at an upper portion of the substrate holder 13 may differ in the thickness of a thin film from those located at an intermediate portion of the substrate holder 13 depending on, for example, the arrangement of substrates on the substrate holder 13 or sputtering conditions. Even in such a case, the present embodiment has an advantage in that use of the plasma generator 61 allows adjustment of the density distribution of a plasma in accordance with difference in film thickness.

In the present embodiment, as described above, pyrolytic boron nitride covers a wall surface of the partition 16 that faces the reaction process zone 60, and a portion of the inner wall surface of the vacuum container 11 that faces the reaction process zone 60, whereby the density of radicals in the reaction process zone 60 is held high. By so doing, more radicals are brought into contact with thin films formed on respective substrates, thereby enhancing the efficiency of plasma processing. In other words, the inner wall surface of the partition 16 and the inner wall surface of the vacuum container 11 are coated with chemically stable pyrolytic boron nitride so as to suppress vanishment of radicals or excited radicals generated in the reaction process zone 60 by the plasma generator 61-such vanishment would otherwise result from reaction of radicals or excited radicals with the wall surface of the partition 16 and the inner wall surface of the vacuum container 11. The partition 16 can direct, toward the substrate holder 13, radicals generated in the reaction process zone 60.

Next will be described an example plasma processing method that uses the above-described sputtering apparatus 1. In the plasma processing method, plasma processing is performed on a thin film of incomplete silicon oxide (SiOₓ₁ (x1 < 2)) that is formed on a substrate by means of sputtering, thereby forming a thin film of silicon oxide (SiOₓ₂ (x1 < x2 ≤ 2)) whose oxidation is more advanced than incomplete silicon oxide. Incomplete silicon oxide is expressed by SiOₓ (x < 2), indicating lack of a constituent oxygen element of silicon oxide SiO₂.

First, substrates and the targets 29a and 29b are set in the sputtering apparatus 1. Specifically, substrates are held on the substrate holder 13. The targets 29a and 29b are held on the magnetron sputter electrodes 21a and 21b, respectively. Silicon (Si) is used as material for the targets 29a and 29b.

Next, the internal pressure of the vacuum container 11 is reduced to a predetermined pressure. The motor 17 is activated to thereby rotate the substrate holder 13. After pressure in the vacuum container 11 is stabilized, the pressure of the film deposition process zone 20 is adjusted to 0.1 Pa to 1.3 Pa.

Next, argon gas as an inert gas for sputtering and oxygen gas as a reactive gas are introduced into the film deposition process zone 20 from the sputter gas container 27 and the reactive gas container 28, respectively, while their flow rates are regulated by means of the mass flow controllers 25 and 26. In this manner, a sputtering atmosphere is adjusted in the film deposition process zone 20.

Next, AC voltage having a frequency of 1 kHz to 100 kHz is applied from the intermediate frequency AC power supply 23 to the magnetron sputter electrodes 21a and 21b via the transformer 24, thereby applying an alternating electric field to the targets 29a and 29b. Thus, at a certain point of time, the target 29a becomes a cathode (negative electrode), whereas the target 29b becomes an anode (positive electrode). At a next point of time when alternating current reverses in direction, the target 29b becomes a cathode (negative electrode), whereas the target 29a becomes an anode (positive electrode). In this manner, the paired targets 29a and 29b alternately become an anode and a cathode, to thereby generate a plasma, whereby a target on a cathode is sputtered.

In the process of sputtering, silicon oxide (SiOₓ (x ≤ 2)), which is nonconductive or of low conductivity, may adhere to an anode. However, when an alternating electric field causes the anode to be changed to a cathode, the adhering silicon oxide (SiOₓ (x ≤ 2)) is sputtered, so that the surface of the target becomes clean again.

The paired targets 29a and 29b alternately become an anode and a cathode repeatedly, so that a stable anode-potential state is established at all times, thereby preventing a change in plasma potential (generally equal to anode potential). Thus, a thin film of silicon or incomplete silicon oxide (SiOₓ₁ (x1 < 2)) is stably formed on the film deposition surface of each substrate.

In the film deposition process zone 20, a thin film can be formed of silicon (Si), silicon oxide (SiO₂), or incomplete silicon oxide (SiOₓ₁ (x1 < 2)) by adjusting the flow rate of oxygen gas to be introduced into the film deposition process zone 20 or by controlling the rotational speed of the substrate holder 13.

After a thin film of silicon or incomplete silicon oxide (SiOₓ₁ (x1 < 2))is formed on the film deposition surface of each substrate in the film deposition process zone 20, the substrate holder 13 is rotated so as to transport substrates from a position where the substrates face the film deposition process zone 20, to a position where the substrates face the reaction process zone 60.

Oxygen gas as a reactive gas and argon gas as an inert gas are introduced into the reaction process zone 60 from the reactive gas container 78 and the inert gas container 77, respectively. Next, voltage having a radio frequency of 13.56 MHz is applied to the antennas 65a and 65b, whereby the plasma generator 61 generates a plasma in the reaction process zone 60. The pressure of the reaction process zone 60 is maintained at 0.7 Pa to 1 Pa.

Next, when, as a result of rotation of the substrate holder 13, substrates on each of which a thin film of silicon or incomplete silicon oxide (SiOₓ₁ (x1 < 2)) has been formed are transported to a position where the substrates face the reaction process zone 60, the thin film of silicon or incomplete silicon oxide (SiOₓ₁ (x1 < 2)) formed on each substrate is oxidized by means of plasma processing in the reaction process zone 60. Specifically, by means of a plasma of oxygen gas that is generated in the reaction process zone 60 by the plasma generator 61, silicon or incomplete silicon oxide (SiOₓ₁ (x1 < 2)) is oxidized to thereby be converted to incomplete silicon oxide having a desired composition (SiOₓ₂ (x1 < x2 < 2)) or to silicon oxide.

By carrying out the above-described process, a thin film of silicon oxide having a desired composition (SiOₓ (x ≤ 2)) can be formed. By repeating the above-described process, thin films are formed in layers, whereby a thin film having a desired thickness can be formed.

Particularly, in the present embodiment, not only oxygen gas as a reactive gas but also argon gas as an inert gas is introduced into the reaction process zone 60, so that the density of radicals of the reactive gas in a plasma can be increased. This effect is shown in FIGS. 5 and 6.

FIG. 5 is a graph showing the proportion of oxygen atoms and oxygen ions contained in a plasma generated in the reaction process zone 60 and shows the comparative test results between the case of introduction of only oxygen gas into the reactive process zone 60 and the case of introduction of a mixture of oxygen gas and argon gas into the reaction process zone 60. In FIG. 5, the horizontal axis represents power to be applied from the RF power supply 69, and the vertical axis represents the emission intensity ratio. The emission intensity ratio is obtained by measuring the emission intensity of excited oxygen radicals and oxygen ions contained in a plasma by optical emission spectroscopy. As seen from FIG. 5, the density of excited oxygen radicals is higher in the case of introducing a mixture of oxygen gas and argon gas (in the case of introducing oxygen gas at 110 sccm and argon gas at 40 sccm) into the reaction process zone 60 than in the case of introducing only oxygen gas at 150 sccm into the reaction process zone 60. The flow rate unit "sccm" represents flow rate per minute at 0°C and 1 atm, and is equal to cm³/min.

FIG. 6 shows the results of measuring the emission intensity of excited oxygen radicals and oxygen ions contained in a plasma by optical emission spectroscopy in the case of introducing a mixture of oxygen gas and argon gas into the reaction process zone 60. In FIG. 6, the horizontal axis represents power to be applied from the RF power supply 69, and the vertical axis represents the emission intensity ratio.

In the present embodiment, as described above, pyrolytic boron nitride coating is applied to the partition 16 and to the vacuum container 11, so that the density of oxygen radicals in a plasma can be maintained at a high level in the reaction process zone 60. This effect is shown in FIG. 7.

FIG. 7 is a graph showing the flow density of oxygen radicals in a plasma generated in the reaction process zone 60 and shows an example of comparative test results between the case where pyrolytic boron nitride (PBN) coating is applied to the partition 16 and to the vacuum container 11 and the case where PBN coating is not applied. In the present example test, in the case where pyrolytic boron nitride coating is applied to the partition 16 and to the vacuum container 11, pyrolytic boron nitride covers the surface of the partition 16 that faces the reactive process zone 60 and the inner surface of the vacuum container 11 that is surrounded by the partition 16 and faces the reaction process zone 60.

In FIG. 7, the horizontal axis represents the flow rate of oxygen gas being introduced into the reaction process zone 60, and the vertical axis represents the flow density of oxygen radicals in a plasma generated in the reaction process zone 60. In FIG. 7, the flow density of oxygen radicals represented along the vertical axis is the absolute flow density. The absolute flow density is obtained from the degree of oxidation of a thin film of silver. Specifically, a substrate on which a thin film of silver is formed is held on the substrate holder 13; a change in the weight of the thin film is obtained by measuring the weight before and after the thin film is subjected to plasma processing in the reaction process zone 60; the degree of oxidation of silver is obtained from the obtained change in the weight of the thin film; and the absolute flow density is calculated from the obtained degree of oxidation. As is apparent from FIG. 7, the flow density of oxygen radicals is high in the case where pyrolytic boron nitride coating is applied to the partition 16 and to the vacuum container 11.

The above description has discussed the case of forming a thin film of silicon oxide having a desired composition (SiOₓ (x ≤ 2)). However, through repeated sputtering by use of a plurality of film deposition process zones instead of a single film deposition process zone, thin films of different compositions can be formed in layers to thereby form a multilayered thin film. For example, as described previously, the film deposition process zone 40 is provided in the sputtering apparatus 1, and niobium (Nb) is used as the targets 49a and 49b. By a method similar to that for forming a thin film of silicon oxide, niobium oxide having a desired composition (NbO_{y} (y < 2.5)) is formed on a thin film of silicon oxide. By cyclically repeating the process of sputtering in the film deposition process zone 20, oxidation through plasma processing in the reaction process zone 60, sputtering in the film deposition process zone 40, and oxidation through plasma processing in the reaction process zone 60, there can be formed a thin film consisting of thin films of silicon oxide having a desired composition (SiOₓ (x ≤ 2)) and thin films of niobium oxide having a desired composition (NbO_{y} (y ≤ 2.5)) that are arranged in alternating layers.

Particularly, according to the present embodiment, use of the plasma generator 61 in the sputtering apparatus 1 imparts high density, good quality, and high functional performance to a deposited thin film. The effect of the plasma generator 61 is apparent from FIGS. 8 and 9.

FIGS. 8 and 9 are graphs showing the transmittance of a multilayered thin film of silicon oxide (SiO₂) and niobium oxide (Nb₂O₅). FIG. 8 shows the test results in the case where a multilayered thin film of niobium oxide and silicon oxide is formed by use of the conventional plasma generator 161 of FIG. 10 in place of the plasma generator 61 of the sputtering apparatus 1. FIG. 9 shows the test results in the case where a multilayered thin film of niobium oxide and silicon oxide is formed by use of the plasma generator 61 of the present embodiment. In FIGS. 8 and 9, the horizontal axis represents measuring wavelength, and the vertical axis represents transmittance.

In the case of using the conventional plasma generator 161, voltage having a power of 5.5 kW was applied from the RF power supply 169, and SiO₂ and Nb₂O₅ were deposited at a rate of 0.3 nm/s and 0.2 nm/s, respectively. The SiO₂ layer and the Nb₂O₅ layer were alternately deposited 17 times in total, thereby forming a thin film having a total physical film thickness of 940 nm. The formed thin film exhibited an attenuation coefficient k of 100 x 10⁻⁵ as measured at a measuring wavelength of 650 nm (FIG. 8).

In the case of the sputtering apparatus 1 of the present embodiment, which employs the plasma generator 61, voltage having a power of 4.0 kW was applied from the RF power supply 69, and SiO₂ and Nb₂O₅ were deposited at a rate of 0.5 nm/s and 0.4 nm/s, respectively. The SiO₂ layer and the Nb₂O₅ layer were alternately deposited 38 times in total, thereby forming a thin film having a total physical film thickness of 3242 nm. The formed thin film exhibited an attenuation coefficient k of 5 x 10⁻⁵ as measured at a measuring wavelength of 650 nm (FIG. 9).

As seen from the test results in the case of forming a multilayered thin film of silicon oxide and niobium oxide by use of the sputtering apparatus 1 of the present embodiment, which employs the plasma generator 61, plasma processing by use of the sputtering apparatus 1 of the present embodiment enables formation of a favorable thin film having a small value of attenuation coefficient (absorption coefficient).

The attenuation coefficient k, the optical constant (complex index of refraction) N, and the index of refraction n hold the relation "N = n + ik."

The above-described embodiment can be modified, for example, as described below in (a) to (j). Variants (a) to (j) may be combined as appropriate for modification of the embodiment.
(a) The above-described embodiment employs inductively-coupled-type (plate-type) plasma generating means, in which, as shown in FIGS. 1 to 3, the antennas 65a and 65b are fixed to the plate-like dielectric wall 63. However, the present invention can be applied to a thin film deposition apparatus that employs another-type plasma generating means. Specifically, even in the case of a thin film deposition apparatus using plasma generating means of a type other than the inductively-coupled-type (plate-type), by means of coating the inner wall surface of the vacuum container and the surface of the plasma converging wall with pyrolytic boron nitride, as in the above-described embodiment, there can be suppressed vanishment of radicals or excited radicals contained in a plasma generated by the plasma generating means-such vanishment would otherwise result from reaction of radicals or excited radicals with the inner wall surface of the vacuum container and with the surface of the plasma converging wall. Examples of plasma generating means of a type other than the inductively-coupled-type (plate-type) include parallel-plate-type (diode-discharge-type) plasma generating means, ECR (Electron Cyclotron Resonance)-type plasma generating means, magnetron-type plasma generating means, helicon-wave-type plasma generating means, and inductively-coupled-type (cylindrical-type) plasma generating means.
(b) The above embodiment is described while mentioning a sputtering apparatus as a thin film deposition apparatus. However, the present invention can be applied to thin film deposition apparatus of other types. Examples of such thin film deposition apparatus include an etching apparatus that performs etching by use of a plasma and a CVD apparatus that performs CVD by use of a plasma. The present invention can also be applied to a surface treatment apparatus that treats plastic surface by use of a plasma.
(c) The above embodiment is described while mentioning a carousel-type sputtering apparatus. However, the present invention is not limited thereto. The present invention can be applied to sputtering apparatus of other types in which substrates are transported while facing a region where a plasma is generated.
(d) According to the above-described embodiment, the protection layer P of pyrolytic boron nitride is formed on the surface of the partition 16 that faces the reaction process zone 60 and on the inner wall surface of the vacuum container 11 that faces the reaction process zone 60. However, the protection layer P of pyrolytic boron nitride may be formed on other portions. For example, pyrolytic boron nitride may cover portions of the partition 16 other than the surface of the partition 16 that faces the reaction process zone 60. This can avoid a reduction in radicals, which would otherwise result from reaction of radicals with the partition 16, to the greatest possible extent. Also, pyrolytic boron nitride may cover a portion of the inner wall surface of the vacuum container 11 other than that facing the reaction process zone 60; for example, the entire inner wall surface may be coated with pyrolytic boron nitride. This can avoid a reduction in radicals, which would otherwise result from reaction of radicals with the inner wall surface of the vacuum container 11, to the greatest possible extent. The partition 12 may be coated with pyrolytic boron nitride.
(e) The above embodiment is described while mentioning pyrolytic boron nitride as material for covering the surface of the partition 16 that faces the reaction process zone 60, and the inner wall surface of the vacuum container 11 that faces the reaction process zone 60. However, aluminum oxide (Al₂O₃), silicon oxide (SiO₂), or boron nitride (BN) may be used as coating material. Coating with such material can also suppress vanishment of radicals or excited radicals contained in a plasma generated by plasma generating means-such vanishment would otherwise result from reaction of radicals or excited radicals with the inner wall surface of the vacuum container and with the surface of the plasma converging wall.
(f) In the above-described embodiment, while the antennas 65a and 65b are held between the dielectric wall 63 and the fixing plates 68a and 68b, the fixing plates 68a and 68b are fixed to the cover 11b by use of the bolts 68c and 68d, thereby fixing the antennas 65a and 65b. However, other fixing methods may be employed so long as the antennas 65a and 65b can be fixed while the distance D therebetween is adjusted as appropriate. For example, the following fixing method may be employed. The antenna 65a is fixed beforehand to the fixing plate 68a, and the antenna 65b is fixed beforehand to the fixing plate 68b. Elongated holes are provided beforehand in the cover 11b in order to allow the bolts 68c and 68d to be slidable in the vertical direction. The fixing plates 68a and 68b are slid in the vertical direction so as to adjust the distance D, and then the bolts 68c and 68d are fastened while the desired distance D is established. Thus, the fixing plates 68a and 68b are fixedly positioned in the vertical direction in relation to the cover 11b.
(g) The above embodiment is described while mentioning copper as material for forming the body member 65a₁ of the antenna 65a, and silver as material for forming the coating layer 65a₂. However, a combination of other materials may be employed so long as a material that is inexpensive, easily worked, and low in electric resistance is used to form the body member 65a₁, and a material lower in electric resistance than the body member 65a₁ is used to form the coating layer 65a₂, in which current concentrates. For example, the body member 65a₁ is formed of aluminum or an aluminum-copper alloy, whereas the coating layer 65a₂ is formed of copper or gold. The body member 65b₁ and the coating layer 65b2 of the antenna 65b may be modified similarly. Also, different materials may be used to form the antenna 65a and the antenna 65b.
(h) The above embodiment is described while mentioning oxygen as a reactive gas to be introduced into the reaction process zone 60. However, for example, an oxidizing gas, such as ozone or dinitrogen monoxide (N₂O), a nitriding gas, such as nitrogen, a carbonizing gas, such as methane, or a fluorinating gas, such as fluorine or carbon tetrafluoride (CF₄), may be introduced into the reaction process zone 60, whereby the present invention can be applied to plasma processing other than that for oxidation treatment.
(i) The above embodiment is described while mentioning silicon as material for the targets 29a and 29b, and niobium as material for the targets 49a and 49b. However, the present invention is not limited thereto, but their oxides may be used. Examples of other usable metals include aluminum (Al), titanium (Ti), zirconium (Zr), tin (Sn), chromium (Cr), tantalum (Ta), tellurium (Te), iron (Fe), magnesium (Mg), hafnium (Hf), nickel-chromium (Ni-Cr), and indium-tin (In-Sn). Compounds of these metals, such as Al₂O₃, TiO₂, ZrO₂, Ta₂O₅, and HfO₂, can also be used. Of course, the same material may be used to form the targets 29a, 29b, 49a, and 49b.
   When these targets are used, the following films, for example, can be formed by plasma processing in the reaction process zone 60: an optical or insulating film of Al₂O₃, TiO₂, ZrO₂, Ta₂O₅, SiO₂, Nb₂O₅, HfO₂, or MgF₂, a conductive film of ITO, a magnetic film of Fe₂O₃, and an ultra-hard film of TiN, CrN, or TiC. Insulating metal compounds, such as TiO₂, ZrO₂, SiO₂, Nb₂O₅, and Ta₂O₅, exhibit a considerably low sputtering rate with resultant poor productivity as compared with metals (Ti, Zr, and Si). Therefore, plasma processing by use of the thin film deposition apparatus of the present invention is effective for forming thin films of such metal compounds.
(j) In the above-described embodiment, the targets 29a and 29b are of the same material, and the targets 49a and 49b are of the same material. However, the targets 29a and 29b or the targets 49a and 49b may be of different materials. As mentioned previously, when targets of the same metal are used, an incomplete reaction product of a single metal is formed on a substrate by sputtering; and when targets of different metals are used, an incomplete reaction product of an alloy is formed on a substrate.

A thin film deposition method that is conceivable from the above-described embodiment, but is not described in CLAIMS, is described below.

In the conceivable thin film deposition method, plasma processing is performed on a thin film by use of a thin film deposition apparatus in which pyrolytic boron nitride covers a plasma converging wall that is provided to project from the inner wall surface of a vacuum container and faces a region where a plasma is generated. The thin film deposition method includes the steps of introducing a mixture of a reactive gas and an inert gas into the plasma generation region; and generating a plasma of the reactive gas.

The thin film deposition method uses the vacuum container in which pyrolytic boron nitride covers the plasma converging wall that is provided to project from the inner wall surface of the vacuum container and faces a region where a plasma is generated. Thus, there can be suppressed vanishment of radicals or excited radicals contained in a generated plasma-such vanishment would otherwise result from reaction of radicals or excited radicals with the plasma converging wall. Therefore, plasma processing can be performed with high efficiency. Introduction of a mixture of a reactive gas and an inert gas into the plasma generation region can increase the density of radicals of the reactive gas in a plasma, so that plasma processing can be performed with high efficiency. Use of the vacuum container having the plasma converging wall allows control of plasma distribution.

### INDUSTRIAL APPLICABILITY

As described above, in the thin film deposition apparatus and the thin film deposition method of the present invention, plasma processing can be performed efficiently over a wide range.

## Claims

1. A thin film deposition apparatus comprising a vacuum container (11) for maintaining a vacuum therein, gas introduction means for introducing a reactive gas into the vacuum container, and plasma generating means (61) for generating a plasma of the reactive gas within the vacuum container (11),
the plasma generating means (61) comprises a dielectric wall (63) provided on an outer wall of the vacuum container (11), a first antenna (65a) having a spiral shape, a second antenna (65b) having a spiral shape, and a conductor wire (66) for connecting the first and second antennas (65a, 65b) to an RF power supply (69); and
the first antenna (65a) and the second antenna (65b) are connected in parallel in relation to the RF power supply (69);
**characterized by**
antenna fixing means (68) for fixing the first and second antennas (65a, 65b) is provided outside of the vacuum container (11) in a position corresponding to the dielectric wall (63); and
position adjusting means (66a, 66b) for enabling adjustment of a distance between the first antenna (65a) and the second antenna (65b) is provided in the conductor wire (66) extending from the RF power supply (69) to the first and second antennas (65a, 65b) at a portion that connects the first antenna (65a) and the second antenna (65b).

2. A thin film deposition apparatus as described in claim 1, wherein a matching box (67) for impedance matching is provided;
the matching box (67) mounts between the plasma generating means (61) and the RF power supply (69); and
the matching box (67) does not have the matching coil for impedance matching.

3. A thin film deposition apparatus as described in claim 1, wherein substrate transport means (13, 17) for transporting substrates is provided in the vacuum container (11);
the transport means (13, 17) transports substrates such that the substrates face a plane in which the first antenna (65a) and the second antenna (65b) form respective spirals; and
the first antenna (65a) and the second antenna (65b) are fixed while being arranged adjacent to each other in a direction intersecting a direction in which the substrates are transported by the substrate transport means (13, 17).

4. A thin film deposition apparatus as described in claim 1, wherein each of the first antenna (65a) and the second antenna (65b) comprises a body member (65a₁, 65b₁) assuming the form of a round tube and formed of a first material, and a coating layer (65a₂, 65b₂) covering a surface of the body member (65a₁, 65b₁) and formed of a second material having electric resistance lower than that of the first material.

## Patentansprüche

1. Dünnschichtauftragvorrichtung, die einen Vakuumbehälter (11), in dem ein Vakuum aufrechterhalten wird, eine Gaseinleiteinrichtung zum Einleiten eines reaktiven Gases in den Vakuumbehälter und eine Plasmaerzeugungseinrichtung (61) zum Erzeugen eines Plasmas des reaktiven Gases in dem Vakuumbehälter (11) umfasst,
wobei die Plasmaerzeugungseinrichtung (61) eine dielektrische Wand (63), die an einer Außenwand des Vakuumbehälters (11) vorhanden ist, eine erste Antenne (65a), die eine Spiralform hat, eine zweite Antenne (65b), die eine Spiralform hat, und einen Leiterdraht (66) umfasst, der die erste und die zweite Antenne (65a, 65b) mit einer HF-Energiequelle (69) verbindet; und
die erste Antenne (65a) und die zweite Antenne (65b) in Bezug auf die HF-Energiequelle (69) parallel verbunden sind;
**dadurch gekennzeichnet, dass**
eine Antennen-Befestigungseinrichtung (68) zum Befestigen der ersten und der zweiten Antenne (65a, 65b) außerhalb des Vakuumbehälters (11) an einer Position vorhanden ist, die der dielelektrischen Wand (63) entspricht; und
eine Positionseinstelleinrichtung (66a, 66b), die Einstellung eines Abstandes zwischen der ersten Antenne (65a) und der zweiten Antenne (65b) ermöglicht, in dem Leiterdraht (66), der sich von der HF-Energiequelle (69) zu der ersten und der zweiten Antenne (65a, 65b) erstreckt, an einem Abschnitt vorhanden ist, der die erste Antenne (65a) und die zweite Antenne (65b) verbindet.

2. Dünnschichtauftragvorrichtung nach Anspruch 1, wobei ein Anpassungsgehäuse (67) für Impedanzanpassung vorhanden ist;
das Anpassungsgehäuse (67) zwischen der Plasmaerzeugungseinrichtung (61) und der HF-Energiequelle (69) angebracht ist; und
das Anpassungsgehäuse (67) die Anpassungsspule für Impedanzanpassung nicht aufweist.

3. Dünnschichtauftragvorrichtung nach Anspruch 1, wobei eine Substrat-Transporteinrichtung (13, 17) zum Transportieren von Substraten in dem Vakuum behälter (11) vorhanden ist;
die Transporteinrichtung (13, 17) Substrate so transportiert, dass die Substrate einer Ebene zugewandt sind, in der die erste Antenne (65a) und die zweite Antenne (65b) jeweilige Spiralen bilden; und
die erste Antenne (65a) und die zweite Antenne (65b) so befestigt sind, dass sie einander in einer Richtung benachbart angeordnet sind, die eine Richtung schneidet, in der die Substrate durch die Substrat-Transporteinrichtung (13, 17) transportiert werden.

4. Dünnschichtauftragvorrichtung nach Anspruch 1, wobei die erste Antenne (65a) und die zweite Antenne (65b) jeweils ein Körperelement (65a₁ 65b₁), das die Form einer runden Röhre hat und aus einem ersten Material besteht, sowie eine Überzugschicht (65a₂, 65b₂) umfassen, die eine Oberfläche des Körperelementes (65a₁, 65b₁) abdeckt und aus einem zweiten Material besteht, dessen elektrischer Widerstand niedriger ist als der des ersten Materials.

## Revendications

1. Dispositif de dépôt de couches minces comprenant un récipient sous vide (11) pour maintenir un vide à l'intérieur, un moyen d'introduction de gaz pour introduire un gaz réactif dans le récipient sous vide et un moyen générateur de plasma (61) pour générer un plasma du gaz réactif dans le récipient sous vide (11),
le moyen générateur de plasma (61) comprend une paroi diélectrique (63) prévue sur une paroi extérieure du récipient sous vide (11), une première antenne (65a) en forme de spirale, une deuxième antenne (65b) en forme de spirale et un fil conducteur 66 pour connecter les première et deuxième antennes (65a, 65b) à une alimentation RF (69) ; et
la première antenne (65a) et la deuxième antenne (65b) sont connectées en parallèle en relation avec l'alimentation RF (69) ;
**caractérisé en ce que**
un moyen de fixation d'antenne (68) pour fixer les première et deuxième antennes (65a, 65b) est prévu à l'extérieur du récipient sous vide (11) dans une position correspondant à la paroi diélectrique (63) ; et
un moyen de réglage de position (66a, 66b) pour permettre de régler la distance entre la première antenne (65a) et la deuxième antenne (65b) est prévu dans le fil conducteur (66) s'étendant depuis l'alimentation RF (69) jusqu'aux première et deuxième antennes (65a, 65b) dans une partie reliant la première antenne (65a) et la deuxième antenne (65b).

2. Dispositif de dépôt de couches minces selon la revendication 1, dans lequel une boîte d'adaptation (67) pour adaptation d'impédance est prévue ;
la boîte d'adaptation (67) est montée entre le moyen générateur de plasma (61) et l'alimentation RF (69) ; et
la boîte d'adaptation (67) ne comporte pas de bobine d'adaptation pour l'adaptation d'impédance.

3. Dispositif de dépôt de couches minces selon la revendication 1, dans lequel un moyen de transport de substrat (13, 17) pour transporter des substrats est prévu dans le récipient sous vide (11) ;
le moyen de transport (13, 17) transporte des substrats de telle sorte que les substrats soient tournés vers un plan dans lequel la première antenne (65a) et la deuxième antenne (65b) forment des spirales respectives ; et
la première antenne (65a) et la deuxième antenne (65b) sont fixes tout en étant agencées de manière adjacente l'une à l'autre dans une direction coupant la direction dans laquelle sont transportés les substrats par le moyen de transport de substrat (13, 17).

4. Dispositif de dépôt de couches minces selon la revendication 1, dans lequel chaque antenne parmi la première antenne (65a) et la deuxième antenne (65b) comprend un élément de corps (65a₁, 65b₁) se présentant sous la forme d'un tube circulaire et formé d'un premier matériau et une couche de revêtement (65a₂, 65b₂) recouvrant une surface de l'élément de corps (65a₁, 65b₁) et formée d'un deuxième matériau ayant une résistance électrique inférieure à celle du premier matériau.
